# EUROPEAN PATENT APPLICATION

(11) **EP 4 646 047 A1**
(43) Date of publication of application: **05.11.2025**
(21) Application number: 25171849.0
(22) Date of filing: 23.04.2025
(51) Int. Cl.: H05K 7/20

(54) **INVERTER**

(30) Priority: 30.04.2024 CN 202410547695
(71) Applicant: Huawei Digital Power Technologies Co., Ltd., Futian District, Shenzhen, Guangdong 518043 (CN)
(72) Inventor: HAO, Yuwei, Shenzhen, 518043 (CN); LIU, Baoqi, Shenzhen, 518043 (CN); SU, Lei, Shenzhen, 518043 (CN); WU, Kangqian, Shenzhen, 518043 (CN); WU, Hao, Shenzhen, 518043 (CN)
(74) Representative: Epping - Hermann - Fischer

(57) **Abstract**

This application provides an inverter. The inverter includes an enclosure, a heat dissipation housing, a fan, and a first inductor assembly. The heat dissipation housing is fastened to an outer side of an enclosure backplane in a stacked manner. The heat dissipation housing includes a first side plate, a second side plate, a backplane, and a top plate that enclose an air duct. An air inlet is provided on a side that is of the air duct and that is away from the top plate, and a first air outlet is provided on a side that is of the air duct and that is away from the backplane. An air intake side of the fan faces the air inlet, and an air exhaust side of the fan faces the top plate. Hot air in the first air outlet is exhausted to a side on which the enclosure is located, to avoid hot air recirculation. The first side plate has a second air outlet, and the second side plate has a third air outlet. This helps increase a total flow rate of air in the entire air duct, to improve heat dissipation efficiency and a heat dissipation capability of the inverter. The first inductor assembly is disposed in the air duct. In this way, the air duct formed by the heat dissipation housing can be fully used to dissipate heat for the first inductor assembly, and integration and miniaturization of the inverter are also improved.

## Description

### TECHNICAL FIELD

This application relates to the field of heat dissipation technologies, and in particular, to an inverter.

### BACKGROUND

In a process of transmitting or using electric energy, a parameter like a voltage or a current of the electric energy needs to be converted or adjusted. For example, in a photovoltaic power generation system, a direct current generated by a solar panel needs to be converted into an alternating current and then the alternating current is output to the outside. This function may be implemented by an inverter. An electronic component like a chip and an inductor assembly in the inverter generates a large amount of heat in a working process, and the heat needs to be dissipated to an external environment in time via a heat dissipation apparatus, to avoid an overtemperature failure of the electronic component. A high-power inverter is usually used outdoors in a harsh environment, and due to limitations of a size and weight, the inverter usually dissipates heat via an air-cooled heat dissipation apparatus.

Higher power of the inverter indicates a larger amount of heat generated by a power component in the inverter and a higher requirement on a heat dissipation capability of the inverter. In addition, the inverter usually includes a large-size inductor assembly. Higher power of the inverter indicates a higher heat dissipation requirement of the inductor assembly. Therefore, how to improve heat dissipation effect of both the inductor assembly and the power component in the inverter, and improve heat dissipation efficiency and a miniaturization degree of the inverter has become an urgent technical problem to resolved currently.

### SUMMARY

This application provides an inverter, to improve a heat dissipation capability of the inverter, ensure service lives and reliability of various components in an enclosure to further prolong a service life of the inverter, and also help improve a power density of the inverter.

This application provides an inverter. The inverter includes an enclosure, a heat dissipation housing, a fan, and a first inductor assembly. The heat dissipation housing is fastened to an outer side of an enclosure backplane of the enclosure in a stacked manner, to dissipate heat for a circuit board assembly inside the enclosure at the outside of the enclosure. Specifically, the heat dissipation housing includes a first side plate, a second side plate, a backplane, and a top plate, the first side plate and the second side plate are respectively connected to two ends of the backplane, the top plate is connected to the backplane, the first side plate, and the second side plate, and the first side plate, the second side plate, the top plate, the backplane, and the enclosure backplane enclose an air duct. An air inlet is provided on a side that is of the air duct and that is away from the top plate, a first air outlet is provided on a side that is of the air duct and that is away from the backplane, and the first air outlet is located at an end that is of the air duct and that is close to the top plate. The fan is located in the air duct and is installed in the heat dissipation housing, an air intake side of the fan faces the air inlet, and an air exhaust side of the fan faces the top plate. The disposing of the fan can increase a flow rate of air in the air duct, to improve a heat dissipation capability of the inverter, and ensure service lives and reliability of various components in the enclosure to further prolong a service life of the entire inverter. The air inlet is located at the lower part of the heat dissipation housing, the first air outlet is located at the upper part of the heat dissipation housing, the air duct extends in a roughly vertical direction, and air flows into the air duct from the air inlet, so that there is high efficiency of hot air whose temperature is increased after heat exchange flowing out from the first air outlet. The first air outlet faces a direction of the inverter away from a wall surface, so that the hot air is exhausted to a side on which the enclosure is located, to avoid hot air recirculation. The first side plate has a second air outlet, the second side plate has a third air outlet, the second air outlet is located at an end that is of the first side plate and that faces the top plate, and the third air outlet is located at an end that is of the second side plate and that faces the top plate. The air duct of the inverter separately exhausts the hot air from the front and two sides. This helps increase a total flow rate of air in the entire air duct, to improve heat dissipation efficiency and the heat dissipation capability of the inverter. The first inductor assembly is disposed in the air duct, and a distance between the first inductor assembly and the top plate is less than a distance between the first inductor assembly and the air inlet, that is, the first inductor assembly is disposed at the end that is of the air duct and that is close to the top plate. The air duct formed by the heat dissipation housing can be fully used to dissipate heat for the first inductor assembly. In addition, the first inductor assembly is disposed in the heat dissipation housing, which helps improve integration and miniaturization of the inverter. An airflow in the air duct encounters certain resistance on a surface of the first inductor assembly, to facilitate the airflow to flow out from the second air outlet and the third air outlet on the two sides. In other words, the first inductor assembly is further disposed to perform a distribution function.

In addition, in this application, the air outlets are provided on the front and the sides that are of the heat dissipation housing and that face the enclosure. In this way, a space requirement on a side that is of the heat dissipation housing and that is away from the enclosure is low, and there is no need to dispose large space to prevent hot air recirculation. Therefore, a requirement for installation space on a back side of the inverter is reduced, which helps reduce space occupied after the inverter is installed.

In a further technical solution, the inverter further includes a heat sink and a power module. The heat sink is located on the side that is of the enclosure backplane and that faces the heat dissipation housing, the power module is located on a side that is of the enclosure backplane and that is away from the heat dissipation housing, and an orthographic projection of the heat sink on the enclosure backplane completely covers an orthographic projection of the power module on the enclosure backplane. The heat sink and the power module are installed on the two sides of the enclosure backplane and are connected in a thermally conductive manner. Specifically, the heat sink and the power module are installed back to back, so that the heat sink is used to dissipate heat for the power module. The second air outlet is located on a side that is of the heat sink and that is away from the air inlet, and the third air outlet is located on the side that is of the heat sink and that is away from the air inlet. The airflow flows out from the second air outlet and the third air outlet only after completely passing through the heat sink, so that the heat sink can fully exchange heat with the heat dissipation airflow, to improve effect of heat dissipation performed by the heat sink for the power module in the enclosure.

The first inductor assembly is located on the side that is of the heat sink and that is away from the air inlet, so that cold air enters the air duct from the air inlet, flows through the heat sink to exchange heat with the heat sink, and then flows to the first inductor assembly to exchange heat with the first inductor assembly.

Specifically, the enclosure further includes an enclosure cover, an enclosure top plate, and an enclosure bottom plate, the enclosure backplane and the enclosure cover are sequentially arranged in a direction away from the heat dissipation housing, and the enclosure top plate is connected to the enclosure backplane and the enclosure cover. The enclosure top plate and the enclosure bottom plate are sequentially arranged in a direction from the first air outlet to the air inlet, and an orthographic projection of the enclosure cover on the backplane of the heat dissipation housing at least partially covers an orthographic projection of the first air outlet on the backplane. The first air outlet is above the enclosure top plate, the enclosure cover protrudes from the enclosure top plate, and the enclosure cover is opposite to the first air outlet. A part that is of the enclosure cover and that protrudes from the enclosure top plate may block the first air outlet, to block the hot air flowing out from the first air outlet, so that the hot air is not easy to blow directly to the front of the inverter. This can protect an operator in front of the inverter and facilitate maintenance and inspection of the inverter by the operator.

In a specific technical solution, a distance S1 between an upper edge of the enclosure cover and a surface of the enclosure top plate and a distance S2 between an upper edge of the first air outlet and the surface of the enclosure top plate meet S1>S2. This helps improve effect of blocking the hot air flowing out from the first air outlet by the enclosure cover, and then improves effect of protecting the operator.

The inverter further includes a second inductor assembly, where the second inductor assembly is located at an end that is of the air duct and that is close to the air inlet. Specifically, a distance between the second inductor assembly and the top plate is greater than a distance between the second inductor assembly and the air inlet. When the inverter includes the heat sink, the second inductor assembly, the heat sink, and the first inductor assembly are sequentially arranged in a direction from the air inlet to the top plate. Cold air of the external environment enters the air duct from the air inlet, and sequentially flows through the second inductor assembly, the heat sink, and the first inductor assembly. In this way, a structure of the heat dissipation housing is used to dissipate heat for the second inductor assembly, the heat sink, and the first inductor assembly. This can fully utilize a heat dissipation capability of the air duct in the heat dissipation housing, and improve the heat dissipation efficiency of the inverter.

The first inductor assembly extends in a direction from the first side plate to the second side plate, and the second inductor assembly extends in the direction from the first side plate to the second side plate. In this way, large-area side surfaces of the first inductor assembly and the second inductor assembly are perpendicular to an air flow direction, to improve heat exchange efficiency.

In a further technical solution, the fan is located between the heat sink and the second inductor assembly. The air inlet, the second inductor assembly, the fan, the heat sink, and the first inductor assembly are sequentially arranged.

The inverter further includes a mesh cover, and the mesh cover is installed at the air inlet of the heat dissipation housing. The mesh cover can prevent foreign matter from entering the air duct and prevent the foreign matter from damaging a structure disposed in the air duct. In addition, the mesh cover is located on a side that is of the second inductor assembly and that is away from the fan. In this way, a distance between the mesh cover and the fan is long, to help reduce noise, also help increase an air intake area at the air duct, reduce air resistance formed by the mesh cover, reduce an airflow speed, and reduce a probability of blocking the mesh cover by dust.

The first inductor assembly is disposed in the middle in the direction from the first side plate to the second side plate. Specifically, a shortest distance L1 between the first inductor assembly and the first side plate and a shortest distance L2 between the first inductor assembly and the second side plate meet -5%L1≤L1-L2<5%L1. This helps the airflow in the air duct to be evenly distributed to the second air outlet and the third air outlet on the two sides, and improves distribution evenness of the airflow in the air duct.

In a technical solution, to pre-install the first inductor assembly, a first limiting part is disposed on a side that is of the backplane and that faces the enclosure, a second limiting part is disposed on a side that is of the first inductor assembly and that faces the backplane, and the first limiting part is assembled with the second limiting part, to limit the first inductor assembly in the direction from the first side plate to the second side plate, and limit the first inductor assembly in a direction from the top plate to the air inlet. In a process of installing the inverter, there is no need to repeatedly reverse a related component like the enclosure of the inverter. An assembly process is simple, and helps improve a yield rate of assembly. In addition, in processes of using and transporting the inverter, cooperation between the first limiting part and the second limiting part may also improve installation reliability of the first inductor assembly, and improve structural stability of the inverter.

In a specific technical solution, the first limiting part includes a limiting slot, the second limiting part includes heat dissipation fins of the first inductor assembly, and at least a part of the heat dissipation fins is accommodated in the limiting slot. In this solution, the heat dissipation fins of the first inductor assembly can be reused, to simplify a structure of the inverter. Specifically, at least two heat dissipation fins of the first inductor assembly may be inserted into at least two limiting slots of the first limiting part, to improve limiting effect.

The backplane of the heat dissipation housing in embodiments of this application includes a first housing plate, a second housing plate, and a third housing plate that are sequentially arranged in the direction from the top plate to the air inlet. A distance between the second housing plate and the enclosure backplane is less than a distance between the first housing plate and the enclosure backplane, and the distance between the second housing plate and the enclosure backplane is less than a distance between the third housing plate and the enclosure backplane. In other words, the second housing plate protrudes relative to the first housing plate and in a direction from the second housing plate to the enclosure backplane. In this way, a cross-sectional area of a region in which the second housing plate is located and that is of the air duct shrinks. There is large space near the air inlet of the air duct for allowing entrance of cold air, so that a large amount of cold air enters the air duct. However, when the cold air flows to the region in which the second housing plate is located, because the air duct shrinks, the cold air in the air duct can be gathered, so that a speed of the cold air is increased, to improve the heat dissipation efficiency of the inverter.

The fan is located between the third housing plate and the enclosure backplane, so that the fan has large installation space. This helps increase a size of the fan, and also helps gather cold air blown out by the fan, to improve a speed of the cold air and heat dissipation efficiency.

There may be a plurality of solutions for disposing the first housing plate, the second housing plate, and the third housing plate. For example, the first housing plate, the second housing plate, and the third housing plate may be an integrated structure or a welding structure, so that a structure of the backplane of the heat dissipation housing is simple.

Alternatively, in an implementation, the backplane includes an air baffle and a sealing plate, the air baffle is fastened to the sealing plate, the air baffle includes a first baffle plate, a second baffle plate, and a second housing plate, the first baffle plate and the second baffle plate are connected to two ends of the second housing plate, and the first baffle plate and the second baffle plate are sequentially arranged in the direction from the top plate to the air inlet. The first baffle plate is closer to the first inductor assembly than the second baffle plate, and the second baffle plate is closer to the air inlet than the first baffle plate. In this solution, the sealing plate and the air baffle of the heat dissipation housing may be separately prepared, and then the sealing plate and the air baffle are fastened in a manner of welding, riveting, clamping, screwing, or the like, to form the air duct with a changed cross-sectional area, for improving heat exchange effect of the air duct.

When the second baffle plate is specifically disposed, because the second baffle plate faces the air inlet, an included angle between the second baffle plate and the second housing plate is an obtuse angle. The second baffle plate may guide an airflow entering from the air inlet, so that the airflow in the air duct flows into space between the second housing plate and the enclosure backplane as soon as possible, that is, flows into the heat sink as soon as possible, to increase a flow rate of the airflow at the heat sink and improve the heat dissipation efficiency of the inverter. In an optional technical solution, the plate is a tilted plate, a curved plate, or the like.

To fully utilize the heat dissipation capability of the heat dissipation housing and improve heat dissipation effect of the first inductor assembly, the first baffle plate has a first opening communicating with the first air outlet, and the second baffle plate has a second opening communicating with the air inlet. In this case, a part of the airflow that enters the air duct from the air inlet may enter between the second housing plate and the sealing plate through the second opening, and then flow out from the first opening. An orthographic projection of the first opening on the top plate at least partially overlaps an orthographic projection of the first inductor assembly on the top plate. The first opening is opposite to the first inductor assembly, and then the airflow flowing out from the first opening may cool the first inductor assembly, to improve heat dissipation effect of a part that is of the first inductor assembly and that is blocked by the air baffle, and further improve a heat dissipation capability of the first inductor assembly.

Further, when the inverter includes the second inductor assembly and a plurality of fans, the plurality of fans and the second inductor assembly are separately located in the air duct, the plurality of fans are sequentially arranged in the direction from the first side plate to the second side plate, and the plurality of fans are located between the second inductor assembly and the second baffle plate. Some fans in the plurality of fans are blocked by the second inductor assembly, and some fans are not blocked by the second inductor assembly. For example, the plurality of fans include a first fan, an orthographic projection of the first fan on the top plate at least partially overlaps an orthographic projection of the second opening on the top plate, and the orthographic projection of the first fan on the top plate and an orthographic projection of the second inductor assembly on the top plate are at least partially staggered. To be specific, at least a part of a region of the first fan is not blocked by the second inductor assembly, and the part that is of the first fan and that is not blocked by the second inductor assembly is opposite to the second opening. Heat dissipation load on the first fan is small, and there is specific surplus load. The surplus load is fully utilized, to improve utilization of the fan, and reduce impact on heat dissipation effect of the heat sink as much as possible.

### BRIEF DESCRIPTION OF DRAWINGS

FIG. 1 is a diagram of a structure of a photovoltaic system according to an embodiment of the present invention;
FIG. 2 is a side sectional view of an inverter according to an embodiment of this application;
FIG. 3 is another side sectional view of an inverter according to an embodiment of this application;
FIG. 4 is a top view of a structure of an inverter according to an embodiment of this application;
FIG. 5 is an exploded view of a structure of an inverter according to an embodiment of this application;
FIG. 6 is a side sectional view of an inverter according to an embodiment of this application;
FIG. 7 is a top view of a structure of an inverter according to an embodiment of this application;
FIG. 8 is another side sectional view of an inverter according to an embodiment of this application;
FIG. 9 is another side sectional view of an inverter according to an embodiment of this application;
FIG. 10 is a top view of a structure of an inverter according to an embodiment of this application;
FIG. 11 is another side sectional view of an inverter according to an embodiment of this application;
FIG. 12 is another side sectional view of an inverter according to an embodiment of this application;
FIG. 13 is another side sectional view of an inverter according to an embodiment of this application;
FIG. 14 is another side sectional view of an air baffle according to an embodiment of this application;
FIG. 15 is a diagram of a structure of an inverter according to an embodiment of this application; and
FIG. 16 is a diagram of a sectional structure of an inverter according to an embodiment of this application.

### Reference numerals:

00: inverter; 01: wall surface;
02: mounting bracket; 1: enclosure;
11: enclosure backplane; 12: enclosure cover;
13: enclosure top plate; 14: enclosure bottom plate;
2: heat dissipation housing;
21a: first side plate; 21b: second side plate;
22: backplane; 221: first housing plate;
222: second housing plate; 223: third housing plate;
224: sealing plate; 225: air baffle;
226: first baffle plate; 2261: first opening;
227: second baffle plate; 2271: second opening;
23: top plate; 24: first air outlet;
25: air inlet; 26: second air outlet;
27: third air outlet; 3: heat sink;
4: first inductor assembly; 5: circuit board assembly;
51: circuit board; 52: power module;
6: fan; 7: second inductor assembly;
8: mesh cover; 91: first limiting part; and
92: second limiting part.

### DESCRIPTION OF EMBODIMENTS

To make the objectives, technical solutions, and advantages of this application clearer, the following further describes this application in detail with reference to the accompanying drawings.

Terms used in the following embodiments are merely intended to describe specific embodiments, but are not intended to limit this application. The terms "one", "a", "the", "the foregoing", "this", and "the one" of singular forms used in this specification and the appended claims of this application are also intended to include expressions such as "one or more", unless otherwise specified in the context clearly.

Reference to "an embodiment", "a specific embodiment", or the like described in the specification means that one or more embodiments of this application include a specific feature, structure, or characteristic described with reference to this embodiment. The terms "include", "have", and their variants all mean "include but are not limited to", unless otherwise specifically emphasized in another manner.

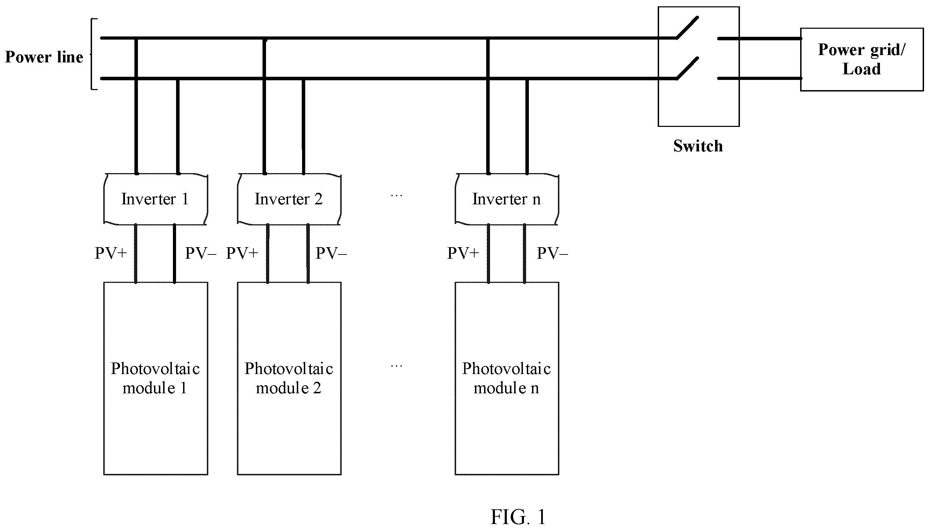

To facilitate understanding of an inverter and a PV plus storage system provided in embodiments of this application, the following first describes an application scenario of the inverter and the PV plus storage system. The PV plus storage system is a power generation system that converts solar energy into electric energy by using photovoltaic effect of a semiconductor material. FIG. 1 is a diagram of a structure of a photovoltaic system according to an embodiment of the present invention. Specifically, refer to FIG. 1. The photovoltaic system usually includes a photovoltaic module and an inverter. An input end of the inverter is connected to a photovoltaic module serving as a direct current power supply, an output end of the inverter is connected to a power grid/load by using a power line, and the inverter serves as a power converter to convert energy provided by the photovoltaic module into an alternating current and output the alternating current to the power grid or the load.

Higher power of the inverter indicates a larger amount of heat generated by a circuit board assembly inside an enclosure of the inverter, and consequently, internal temperature of the enclosure rises, which is very unfavorable to heating components disposed inside the enclosure. Especially for some power modules with high heat consumption density, the failure risk of the power modules increases significantly under the influence of continuous high temperature. In addition, an inductor assembly in the inverter is also an important component. In the conventional technology, heat dissipation of the inductor assembly is to package the inductor assembly in an inductor box and install the inductor box outside the enclosure, so that an external environment is used to directly dissipate heat for the inductor assembly, which is not conducive to improving a miniaturization degree of the inverter.

In the conventional technology, hot air generated in a process of air-cooled heat dissipation of the inverter is exhausted to a wall surface. Under the action of diversion of the wall surface, the hot air easily flows back to an air inlet of cold air, and consequently, heat dissipation efficiency of the inverter is reduced. In addition, with the development of miniaturization of the inverter, a problem of hot air recirculation is more prominent. As a result, effective cooling cannot be implemented inside the enclosure of the inverter, and service lives and reliability of various components in the enclosure cannot be ensured to further affect a service life of the entire inverter.

For the foregoing problems, in embodiments of this application, a heat dissipation manner of the inverter, a layout of the inductor assembly, and the like are improved, to implement effective heat dissipation of the inverter, reduce the failure risk of the power module inside the inverter, improve use reliability of the inverter, and improve integration and miniaturization of the inverter. The following specifically describes the inverter provided in embodiments of this application with reference to the accompanying drawings.

It should be noted that the inductor assembly mentioned in embodiments of this application may be an assembly integrating a plurality of inductor components; or in addition to an inductor, the inductor assembly further includes structures such as heat dissipation fins and an inductor box for accommodating the inductor, and the structures are assembled into one inductor assembly. The inductor assembly may be electrically connected to a circuit board assembly in the enclosure in a working process.

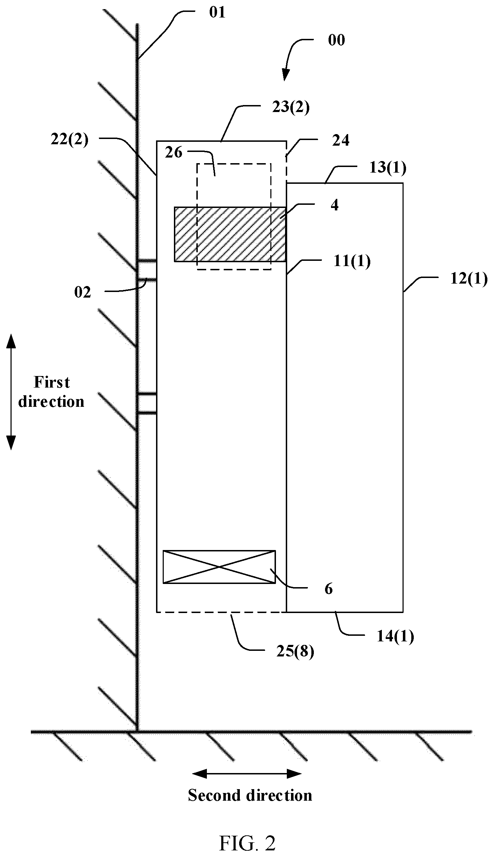

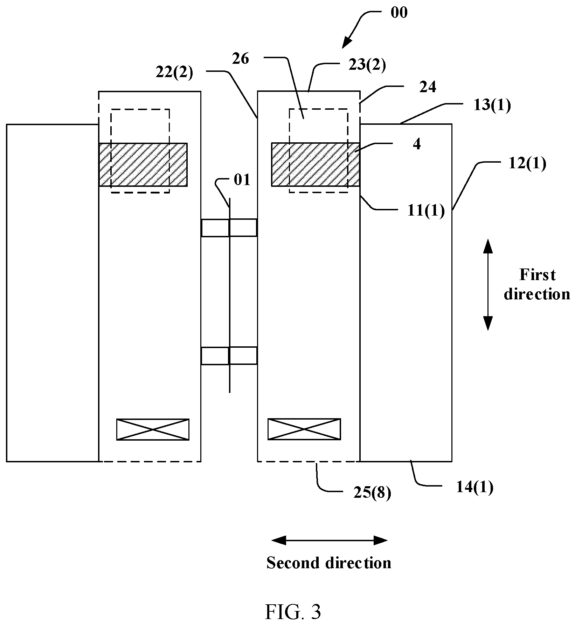

FIG. 2 is a side sectional view of an inverter according to an embodiment of this application. FIG. 3 is another side sectional view of an inverter according to an embodiment of this application. Refer to FIG. 2 and FIG. 3. In embodiments, an inverter 00 may be installed on a wall surface 01. Specifically, the inverter 00 may be mounted on the wall surface 01 via a mounting bracket 02. The wall surface 01 may be a device housing, a wall, or an auxiliary mounting surface. In the embodiment shown in FIG. 2, the inverter 00 may be independently installed on the wall; or in the embodiment shown in FIG. 3, two inverters 00 may be installed back to back, and the auxiliary mounting surface serving as the wall surface 01 is provided between the two inverters 00.

Refer to FIG. 2 and FIG. 3. The inverter 00 includes an enclosure 1, a heat dissipation housing 2, a first inductor assembly 4, and a fan 6, where the heat dissipation housing 2 is fastened to the enclosure 1 in a stacked manner, and the heat dissipation housing 2 is located on an outer side of an enclosure backplane 11 of the enclosure 1. Specifically, the heat dissipation housing 2 is located on a side that is of the enclosure 1 and that faces the wall surface 01, or a side that is of the inverter 00 and that has the heat dissipation housing 2 is installed facing the wall surface 01.

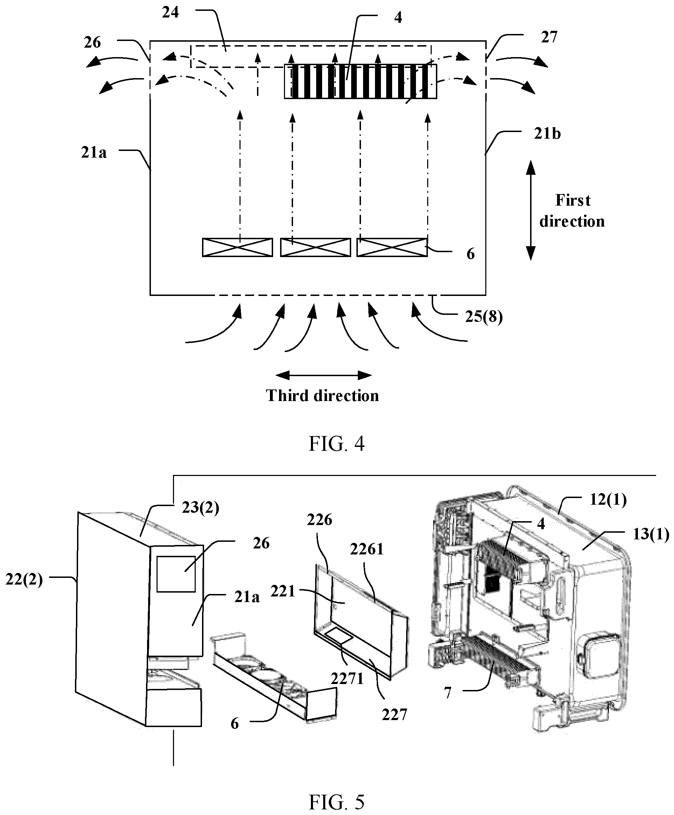

FIG. 4 is a top view of a structure of an inverter according to an embodiment of this application. FIG. 5 is an exploded view of a structure of an inverter according to an embodiment of this application. With reference to FIG. 2 to FIG. 5, the heat dissipation housing 2 includes a first side plate 21a, a second side plate 21b, a backplane 22, and a top plate 23. The first side plate 21a and the second side plate 21b are respectively connected to two ends of the backplane 22. The enclosure 1 includes an enclosure backplane 11 and an enclosure cover 12. The enclosure backplane 11 and the enclosure cover 12 are spaced apart in a direction away from the wall surface 01, and the enclosure backplane 11 is located on a side facing the heat dissipation housing 2. That is, the enclosure backplane 11 and the enclosure cover 12 are sequentially arranged in a direction away from the heat dissipation housing 2. In an embodiment, the first side plate 21a is connected between the backplane 22 and the enclosure backplane 11, and the second side plate 21b is also connected between the backplane 22 and the enclosure backplane 11, so that the first side plate 21a, the backplane 22, the second side plate 21b, and the enclosure backplane 11 are enclosed into a tubular shape. The top plate 23 is connected among the backplane 22, the first side plate 21a, and the second side plate 21b, so that the first side plate 21a, the second side plate 21b, the top plate 23, the backplane 22, and the enclosure backplane 11 enclose an air duct. An air inlet 25 is provided on a side that is of the air duct and that is opposite to the top plate 23, that is, the air inlet 25 of the air duct is located at the lower part of the inverter 00, and external cold air enters the air duct from the lower part of the inverter 00. A first air outlet 24 is provided on a side that is of the air duct and that is away from the backplane 22, and the first air outlet 24 protrudes from a top surface of the enclosure 1, that is, the first air outlet 24 faces a direction in which the inverter 00 is away from the wall surface 01, so that hot air is exhausted to a side that is away from the wall surface 01, to avoid hot air recirculation. In other words, the first air outlet 24 faces a direction in which the enclosure 1 is located, so that the hot air is exhausted to a side on which the enclosure 1 is located. The fan 6 is located in the air duct and is installed in the heat dissipation housing 2, an air intake side of the fan faces the air inlet, and an air exhaust side of the fan faces the top plate. The disposing of the fan 6 can increase a flow rate of air in the air duct, to improve a heat dissipation capability of the inverter, and ensure service lives and reliability of various components in the enclosure to further prolong a service life of the entire inverter. When the inverter 00 is specifically installed, the top plate 23 is located at the top of the heat dissipation housing 2, and the first air outlet 24 is located at an end that is of the air duct and that is close to the top plate 23. In this way, the air duct extends roughly in a vertical direction, the air inlet 25 is located at the lower part, and the first air outlet 24 is located at the upper part, to help improve efficiency of hot air whose temperature is increased in the air duct flowing out from the first air outlet 24.

In addition, in this application, the air outlets are provided on the front and the sides that are of the heat dissipation housing and that face the enclosure. In this way, a space requirement on a side that is of the heat dissipation housing and that is away from the enclosure is low, and there is no need to dispose large space to prevent hot air recirculation. Therefore, a requirement for installation space on a back side of the inverter is reduced, which helps reduce space occupied after the inverter is installed.

For ease of description, it is considered that the air inlet 25 and the top plate 23 are disposed opposite to each other in a first direction, the backplane 22 and the enclosure backplane 11 are disposed opposite to each other in a second direction, and the first side plate 21a and the second side plate 21b are disposed opposite to each other in a third direction. It may be understood that the first direction, the second direction, and the third direction are disposed in pairs at an included angle. For example, the first direction, the second direction, and the third direction may be respectively a height direction, a thickness direction, and a length direction of the inverter 00 in a use state, and the three directions are perpendicular to each other. The airflow in the air duct flows roughly in the first direction.

Still refer to FIG. 4 and FIG. 5. In addition to the first air outlet 24, the heat dissipation housing 2 in this application further includes a second air outlet 26 and a third air outlet 27. The second air outlet 26 is located at an end that is of the first side plate 21a and that faces the top plate 23, and the third air outlet 27 is located at an end that is of the second side plate 21b and that faces the top plate 23. Therefore, in embodiments of this application, the air duct of the inverter 00 exhausts the hot air from the front and two sides. This helps increase a total flow rate of air in the entire air duct, to improve heat dissipation efficiency and the heat dissipation capability of the inverter 00.

In addition, refer to FIG. 2 to FIG. 5. In embodiments of this application, the first inductor assembly 4 is disposed in the air duct, and a distance between the first inductor assembly 4 and the top plate 23 is less than a distance between the first inductor assembly 4 and the air inlet. In embodiments, the air duct formed by the heat dissipation housing 2 can be fully used to dissipate heat for the first inductor assembly 4. In addition, the first inductor assembly 4 is disposed in the heat dissipation housing 2, which helps improve integration and miniaturization of the inverter 00.

In addition, the first inductor assembly 4 is located between the air inlet and the first air outlet 24, so that the airflow in the air duct encounters certain resistance on a surface of the first inductor assembly 4, to facilitate the airflow to flow out from the second air outlet 26 and the third air outlet 27 on the two sides. In other words, the first inductor assembly 4 is disposed to implement a distribution function.

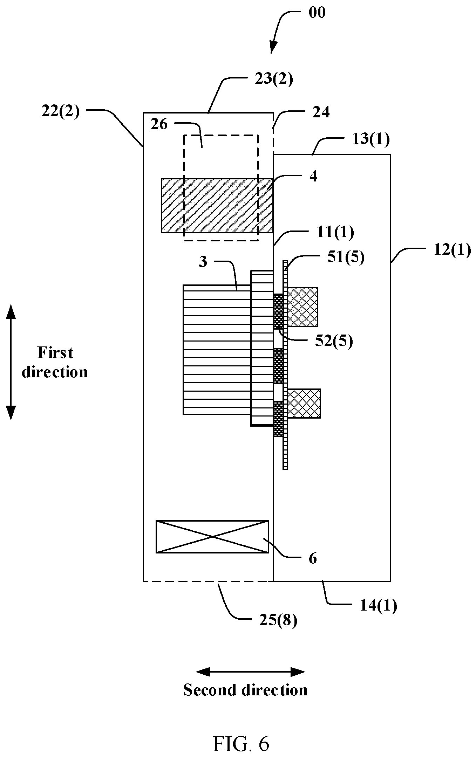

FIG. 6 is a side sectional view of an inverter according to an embodiment of this application. As shown in FIG. 6, a circuit board assembly 5 is disposed in the foregoing enclosure 1, and the circuit board assembly 5 includes a circuit board 51 and a power module 52 located on the circuit board 51. The power module 52 may include various power components such as a chip, a resistor, and a capacitor, and these power components may be combined and connected according to a specific function to implement the specific function. The chip may include an insulated gate bipolar transistor (insulated gate bipolar transistor, IGBT), a metal-oxide-semiconductor field-effect transistor (metal-oxide-semiconductor field-effect transistor, MOSFET), a power transistor (power transistor), or the like.

The inverter further includes a heat sink 3. The heat sink 3 is located on a side that is of the enclosure backplane 11 and that faces the heat dissipation housing 2, the power module 52 is located on a side that is of the enclosure backplane 11 and that is away from the heat dissipation housing 2, and an orthographic projection of the heat sink 3 on the enclosure backplane 11 completely covers an orthographic projection of the power module 52 on the enclosure backplane 11. The heat sink 3 is located in the air duct, and in the first direction, the heat sink 3 is located between the air inlet 25 and the first air outlet 24, so that cold air in the air duct can fully exchange heat with the heat sink 3. In the second direction, the heat sink 3 and the power module 52 of the circuit board assembly 5 in the enclosure 1 are sequentially arranged, and the heat sink 3 is connected to the power module 52 in the enclosure 1 in a thermally conductive manner. Specifically, when the heat sink 3 is connected to the power module 52 in the enclosure 1 in a thermally conductive manner, the heat sink 3 and a side surface of the enclosure backplane 11 may be in contact or may be connected by using a thermally conductive material like a thermally conductive adhesive, and the power module 52 and another side surface of the enclosure backplane 11 are in contact or is connected by using the thermally conductive material like the thermally conductive adhesive, so that the enclosure backplane 11 is used to transfer heat between the power module 52 and the heat sink 3, and the heat sink 3 is used to dissipate heat for the power module 52. In a specific embodiment, an orthographic projection of the power module 52 on the enclosure backplane 11 in the second direction at least partially overlaps an orthographic projection of the heat sink 3 on the enclosure backplane 11 in the second direction. Further, the orthographic projection of the power module 52 on the enclosure backplane 11 in the second direction is completely located in the orthographic projection of the heat sink 3 on the enclosure backplane 11 in the second direction, to improve heat dissipation effect of the power module 52.

The first inductor assembly 4 is located on a side that is of the heat sink 3 and that faces the first air outlet 24, or the first inductor assembly 4 is located on a side that is of the heat sink 3 and that is away from the air inlet 25. Cold air enters the air duct from the air inlet 25, flows through the heat sink 3 to exchange heat with the heat sink 3, and then flows to the first inductor assembly 4 to exchange heat with the first inductor assembly 4. The first inductor assembly 4 extends in a direction from the first side plate 21a to the second side plate 21b. The first inductor assembly 4 is in a long strip shape. Therefore, it may be considered that the first inductor assembly 4 includes sizes in three directions: a long side, a wide side, and a high side, which are respectively a length, a width, and a height. If the length of the first inductor assembly 4 is greater than the width and the height, an extension direction of the long side of the first inductor assembly 4 is an extension direction of the first inductor assembly 4. The first inductor assembly 4 extends in the third direction, that is, the extension direction of the first inductor assembly 4 is the same as the third direction. In this embodiment, the cold air in the air duct flows in the first direction, and the first direction is perpendicular to the third direction. Therefore, an area in which the first inductor assembly 4 performs heat exchange with the cold air may be increased, and heat dissipation effect of the first inductor assembly 4 is improved.

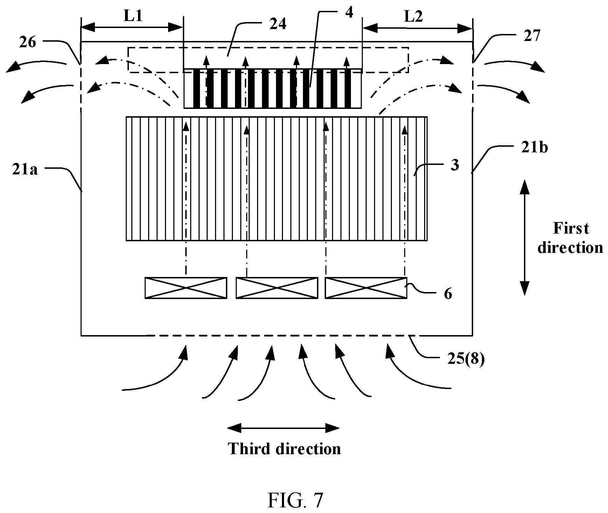

FIG. 7 is a top view of a structure of an inverter according to an embodiment of this application. As shown in FIG. 7, in a specific embodiment, a shortest distance L1 between the first inductor assembly 4 and the first side plate 21a and a shortest distance L2 between the first inductor assembly 4 and the second side plate 21b meet -5%L1≤L1-L2≤5%L1. In conclusion, a difference between the shortest distance L1 between the first inductor assembly 4 and the first side plate 21a and the shortest distance L2 between the first inductor assembly 4 and the second side plate 21b is not greater than 5%. In a first embodiment, the first inductor assembly 4 and the air duct are in a middle region in the third direction. This helps the airflow in the air duct to be evenly distributed to the second air outlet 26 and the third air outlet 27 on the two sides.

In some layout solutions with special application scenarios or components, as shown in FIG. 5, the first inductor assembly 4 may also be close to the first side plate 21a or the second side plate 21b.

In the first direction, the second air outlet 26 is located on the side that is of the heat sink 3 and that is away from the air inlet 25, and the third air outlet 27 is also located on the side that is of the heat sink 3 and that is away from the air inlet 25. In this embodiment, the airflow flows out from the second air outlet 26 and the third air outlet 27 only after completely passing through the heat sink 3, so that the heat sink 3 can fully exchange heat with the heat dissipation airflow, to improve effect of heat dissipation performed by the heat sink 3 for the power module 52 in the enclosure 1.

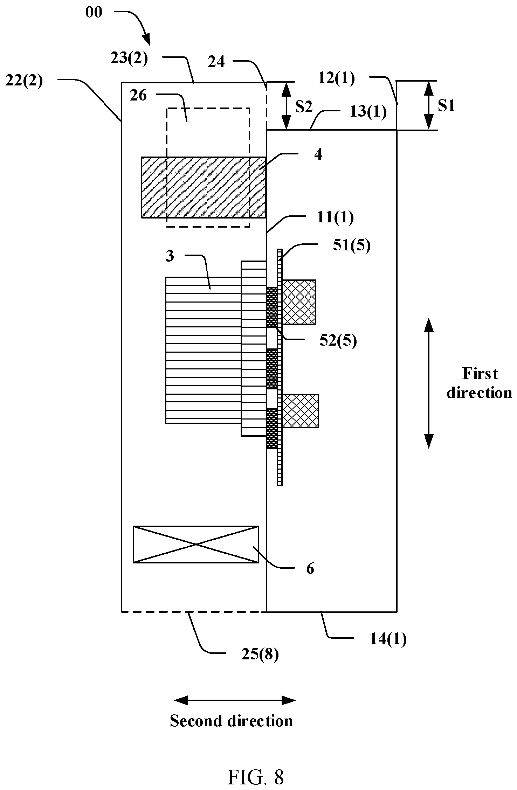

FIG. 8 is another side sectional view of an inverter according to an embodiment of this application. As shown in FIG. 8, the enclosure 1 further includes an enclosure top plate 13 and an enclosure bottom plate 14. The enclosure backplane 11 and the enclosure cover 12 are sequentially arranged in the direction away from the heat dissipation housing 2. The enclosure top plate 13 is connected to the enclosure backplane 11 and the enclosure cover 12. The enclosure top plate 13 and the enclosure bottom plate 14 are sequentially arranged in a direction from the first air outlet 24 to the air inlet 25. That is, the enclosure backplane 11 and the enclosure cover 12 are spaced apart in the second direction, and the enclosure backplane 11 is located between the enclosure cover 12 and the heat dissipation housing 2. The enclosure top plate 13 and the enclosure bottom plate 14 are spaced apart in the first direction, and the enclosure top plate 13 is located above the enclosure bottom plate. In other words, an arrangement direction of the enclosure bottom plate 14 and the enclosure top plate 13 is the same as an arrangement direction from the air inlet 25 to the top plate 23 of the heat dissipation housing 2. The circuit board assembly 5 in the enclosure 1 is located between the enclosure bottom plate 14 and the enclosure top plate 13 in the first direction, and is located between the enclosure backplane 11 and the enclosure cover 12 in the second direction.

The enclosure 1 may further include two side plates, and the two side plates, the enclosure top plate 13, the enclosure bottom plate 14, the enclosure backplane 11, and the enclosure cover 12 make the enclosure 1 enclose a cube cavity. In an embodiment, an inner cavity of the enclosure 1 may be specifically a closed cavity. In this way, in the inverter 00, a component that has a high requirement on performance such as waterproofing, dustproofing, or anticorrosion may be disposed in the inner cavity of the enclosure 1.

In the embodiment shown in FIG. 8, the enclosure cover 12 protrudes from the enclosure top plate 13, and an orthographic projection of the enclosure cover 12 on the backplane 22 of the heat dissipation housing 2 at least partially covers an orthographic projection of the first air outlet 24 on the backplane 22. The first air outlet 24 of the heat dissipation housing 2 faces the enclosure 1, and is close to the enclosure top plate 13. Hot air flowing out from the first air outlet 24 flows along the enclosure top plate 13. In this embodiment of this application, the enclosure cover 12 of the enclosure 1 is disposed to protrude from the enclosure top plate 13, so that the enclosure cover 12 protruding from the enclosure top plate 13 can be used to block the hot air flowing out from the first air outlet 24, and the hot air is not easy to blow directly to the front of the inverter 00. This can protect an operator in front of the inverter 00 and facilitate maintenance and inspection of the inverter 00 by the operator.

Refer to FIG. 8. In a further embodiment, a distance S1 between an upper edge of the enclosure cover 12 and a surface of the enclosure top plate 13 and a distance S2 between an upper edge of the first air outlet 24 and the surface of the enclosure top plate 13 meet S1≥S2. In an embodiment, an orthographic projection of the enclosure cover 12 on the backplane 22 of the heat dissipation housing 2 in the second direction completely covers an orthographic projection of the first air outlet 24 on the backplane 22 of the heat dissipation housing 2 in the second direction. This solution helps improve effect of blocking the hot air flowing out from the first air outlet 24 by the enclosure cover 12, and then improves effect of protecting the operator.

It should be noted that the upper edge of the enclosure cover 12 is an edge of the enclosure cover in a direction away from the air inlet. In other words, the upper edge of the enclosure cover 12 is an edge that is of the enclosure cover 12 and that is farthest away from the air inlet. The upper edge of the first air outlet 24 is an edge of the first air outlet 24 in the direction away from the air inlet. In other words, the upper edge of the first air outlet 24 is an edge that is of the first air outlet 24 and that is farthest away from the air inlet.

Specifically, when the distance S1 between the upper edge of the enclosure cover 12 and the surface of the enclosure top plate 13 and the distance S2 between the upper edge of the first air outlet 24 and the surface of the enclosure top plate 13 meet S1>S2, the enclosure cover 12 has better effect of blocking the hot air flowing out from the first air outlet 24. When S1=S2, a part of the enclosure 1 above the inverter 00 does not protrude from the heat dissipation housing 2, and a size of the part above the inverter 00 does not need to be excessively large, that is, a size of the inverter 00 in the first direction does not need to be excessively large, to help implement miniaturization of the inverter 00.

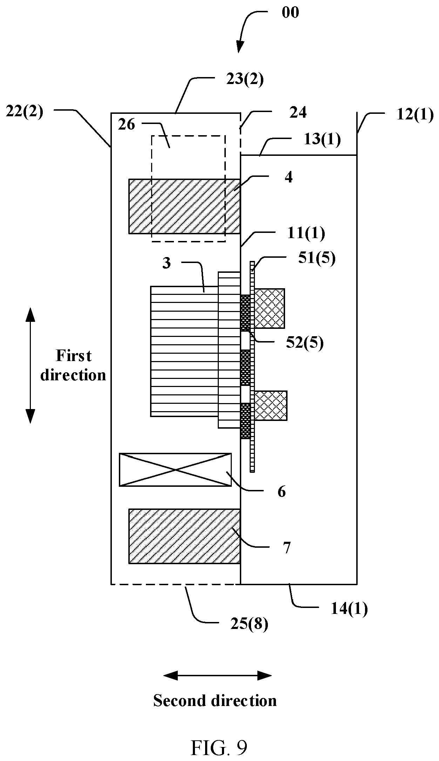

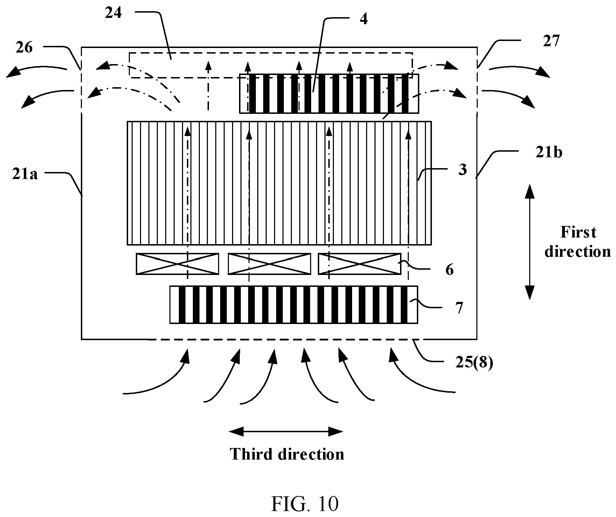

FIG. 9 is another side sectional view of an inverter according to an embodiment of this application. FIG. 10 is a top view of a structure of an inverter according to an embodiment of this application. As shown in FIG. 9 and FIG. 10, in embodiments of this application, the inverter 00 further includes a second inductor assembly 7, and the second inductor assembly 7 is located at an end that is of the air duct and that is close to the air inlet. Specifically, a distance between the second inductor assembly 7 and the top plate 23 is greater than a distance between the second inductor assembly 7 and the air inlet 25. The second inductor assembly 7 is located on a side that is of the heat sink 3 and that is away from the first inductor assembly 4. That is, the air inlet 25, the second inductor assembly 7, the heat sink 3, and the first inductor assembly 4 are sequentially arranged in the first direction. Cold air of the external environment enters the air duct from the air inlet 25, and sequentially flows through the second inductor assembly 7, the heat sink 3, and the first inductor assembly 4. In this way, a structure of the heat dissipation housing 2 is used to dissipate heat for the second inductor assembly 7, the heat sink 3 (the power module in the enclosure 1), and the first inductor assembly 4. This can fully utilize a heat dissipation capability of the air duct in the heat dissipation housing 2, and improve the heat dissipation efficiency of the inverter 00.

In the technical solution of this application, the second inductor assembly 7 extends in a direction from the first side plate 21a to the second side plate 21b. The second inductor assembly 7 is in a long strip shape. Therefore, it may be considered that the second inductor assembly 7 includes sizes in three directions: a long side, a wide side, and a high side, which are respectively a length, a width, and a height. If the length of the second inductor assembly 7 is greater than the width and the height, an extension direction of the long side of the second inductor assembly 7 is an extension direction of the second inductor assembly 7. The second inductor assembly 7 extends in the third direction, that is, the extension direction of the second inductor assembly 7 is the same as the third direction. In this embodiment, the cold air in the air duct flows in the first direction, and the first direction is perpendicular to the third direction. Therefore, an area in which the second inductor assembly 7 performs heat exchange with the cold air may be increased, and the cold air directly blows the second inductor assembly 7, which helps improve efficiency of heat exchange between the cold air and the second inductor assembly 7 and improve heat dissipation effect of the second inductor assembly 7. In embodiments, the air duct formed by the heat dissipation housing 2 can be fully used to dissipate heat for the second inductor assembly 7. In addition, the second inductor assembly 7 is disposed in the heat dissipation housing 2, which helps improve integration and miniaturization of the inverter 00.

As shown in FIG. 9 and FIG. 10, the inverter 00 in embodiments of this application further includes the fan 6. The fan 6 is also installed in the heat dissipation housing 2, and is located in the air duct. The air intake side of the fan 6 faces the air inlet 25, the air exhaust side faces the top plate 23, and the fan 6 is located between the second inductor assembly 7 and the heat sink 3 in the first direction. That is, the air inlet 25, the second inductor assembly 7, the fan 6, the heat sink 3, and the first inductor assembly 4 are sequentially arranged in the first direction. The cold air of the external environment enters the air duct from the air inlet 25 under the driving of the fan 6, and sequentially flows through the second inductor assembly 7, the fan 6, the heat sink 3, and the first inductor assembly 4. In this embodiment of this application, the cold air enters from the air inlet 25 under the driving of the fan 6. Because the second inductor assembly 7 is disposed on a side that is of the fan 6 and that is away from the heat sink 3, there is a specific distance between an edge of the air intake side of the fan 6 and the air inlet 25, to prevent hot air blown out of the first air outlet 24 from recirculating to the air inlet 25 of the heat dissipation housing 2. Therefore, the solution helps reduce the temperature of the cold air in the heat dissipation air duct, improve the heat dissipation efficiency of the circuit board assembly 5 in the enclosure 1, improve the heat dissipation capability of the inverter 00, and ensure service lives and reliability of various components in the enclosure 1 to further prolong a service life of the entire inverter 00.

Refer to FIG. 9 and FIG. 10. In a technical solution, the inverter 00 further includes a mesh cover 8. The mesh cover 8 is disposed on the heat dissipation housing 2, and is installed at the air inlet 25 of the heat dissipation housing 2. Specifically, the mesh cover 8 is opposite to the air inlet 25. In a process of entering the air duct through the air inlet 25, the cold air passes through the mesh cover 8, and then enters the air duct. In this embodiment, the mesh cover 8 can prevent foreign matter from entering the air duct and prevent the foreign matter from damaging a structure disposed in the air duct. In addition, the mesh cover 8 is located on a side that is of the second inductor assembly 7 and that is away from the fan 6. In this way, a distance between the mesh cover 8 and the fan 6 is long, to help reduce noise also help increase an air intake area at the air duct, reduce air resistance formed by the mesh cover 8, reduce an airflow speed, and reduce a probability of blocking the mesh cover 8 by dust.

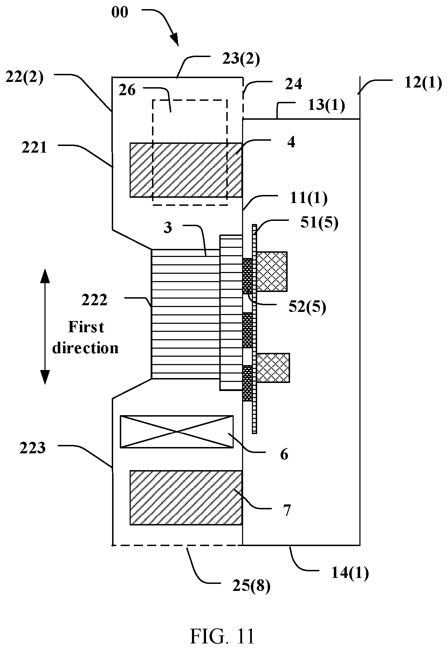

FIG. 11 is another side sectional view of an inverter according to an embodiment of this application. As shown in FIG. 11, in this embodiment of this application, the backplane 22 includes a first housing plate 221, a first baffle plate 226, a second housing plate 222, a second baffle plate 227, and a third housing plate 223 that are sequentially connected in the direction from the top plate 23 to the air inlet 25. A distance between the second housing plate 222 and the enclosure backplane 11 is less than a distance between the first housing plate 221 and the enclosure backplane 11, and the distance between the second housing plate 222 and the enclosure backplane 11 is less than a distance between the third housing plate 223 and the enclosure backplane 11. In other words, the second housing plate 222 protrudes relative to the first housing plate 221 and in a direction from the second housing plate 222 to the enclosure backplane 11. In this embodiment, an area of a cross section of the air duct on the second housing plate 222 in a direction perpendicular to the first direction is less than an area of a cross section of the air duct on the first housing plate 221 in the direction perpendicular to the first direction; and the area of the cross section of the air duct on the second housing plate 222 in the direction perpendicular to the first direction is less than an area of a cross section of the air duct on the third housing plate 223 in the direction perpendicular to the first direction. In this case, there is large space near the air inlet 25 of the air duct for allowing entrance of cold air, so that a large amount of cold air enters the air duct. However, when the cold air flows to a region in which the second housing plate 222 is located, because the air duct shrinks, the cold air in the air duct can be gathered, so that a speed of the cold air is increased, to improve the heat dissipation efficiency of the inverter 00.

In an embodiment, the fan 6 is located between the third housing plate 223 and the enclosure backplane 11. In this solution, the fan 6 has large installation space. This helps increase a size of the fan 6, and also helps gather cold air blown out by the fan 6, to improve a speed of the cold air and heat dissipation efficiency.

In addition, as shown in FIG. 11, in this embodiment of this application, a height of the first inductor assembly 4 in the second direction is greater than a height of the heat sink 3 in the second direction, and a height of the second inductor assembly 7 in the second direction is greater than a height of the heat sink 3 in the second direction. Disposing of the first housing plate 221, the second housing plate 222, and the third housing plate 223 in the backplane 22 may further adapt to arrangement of the first inductor assembly 4, the heat sink 3, and the second inductor assembly 7. The first inductor assembly 4 is located between the first housing plate 221 and the enclosure backplane 11, and the heat sink 3 is located between the second housing plate 222 and the enclosure backplane 11. The second inductor assembly 7 is located between the third housing plate 223 and the enclosure backplane 11, so that space in the heat dissipation housing 2 can be fully used, to improve integration and miniaturization of the inverter 00.

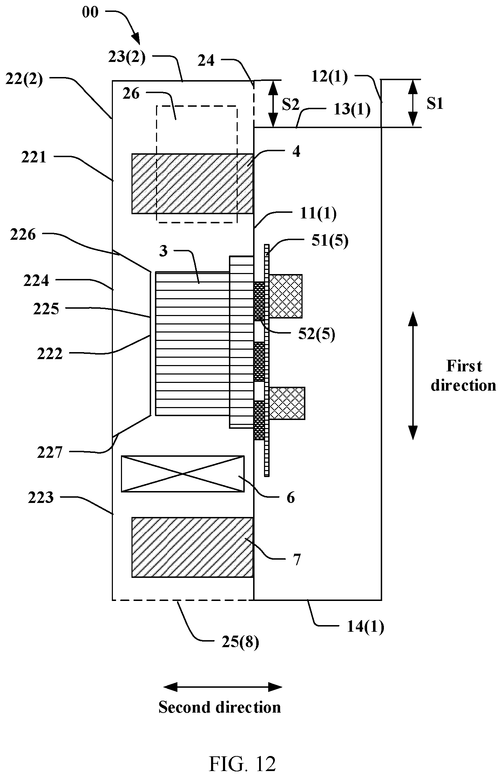

In a specific embodiment, the second housing plate 222 is disposed in contact with the heat sink 3 (as shown in FIG. 11). Alternatively, FIG. 12 is another side sectional view of an inverter according to an embodiment of this application. As shown in FIG. 12, there is a gap between the second housing plate 222 and the heat sink 3, and the gap is less than a first threshold, to reduce or avoid cold air passing by the heat sink 3 between the heat sink 3 and the second housing plate 222. This can improve the heat dissipation effect of the heat sink 3.

As shown in FIG. 11, in an implementation, the first housing plate 221, the first baffle plate 226, the second housing plate 222, the second baffle plate 227, and the third housing plate 223 are of an integrated structure, and may be specifically formed by using a process like sheet metal or welding. This solution helps simplify a quantity of accessories of the inverter 00, reduce preparation steps of the inverter 00, and reduce costs of the inverter 00.

As shown in FIG. 12, in an implementation, the backplane 22 of the heat dissipation housing 2 includes a sealing plate 224 and an air baffle 225. The air baffle 225 is fastened to a side that is of the sealing plate 224 and that faces the heat sink 3. The sealing plate 224 includes a first housing plate and a third housing plate that are spaced apart in a direction from the top plate to the air inlet. The air baffle is fastened to the sealing plate, and the air baffle is located between the first housing plate and the third housing plate. It may be understood that the sealing plate 224, the air baffle 225, the heat sink 3, and the enclosure backplane 11 are sequentially arranged in the second direction. The air baffle 225 includes a first baffle plate 226, a second baffle plate 227, and a second housing plate 222. The first baffle plate 226 and the second baffle plate 227 are connected to two ends of the second housing plate 222, and the first baffle plate 226 and the second baffle plate 227 are sequentially arranged in the direction from the top plate 23 to the air inlet 25. That is, the first baffle plate 226 is closer to the first inductor assembly 4 than the second baffle plate 227, and the second baffle plate 227 is closer to the air inlet 25 than the first baffle plate 226. In an embodiment, the first baffle plate 226 and the first inductor assembly 4 are adjacently disposed, and the second baffle plate 227 and the fan 6 are adjacently disposed. A part that is of the sealing plate 224 and that is located in a direction from the second baffle plate 227 to the top plate 23 is the third housing plate 223, and a part that is of the sealing plate 224 and that is located in a direction from the first baffle plate 226 to the top plate 23 is the first housing plate. Therefore, a distance between the second housing plate 222 and the enclosure backplane 11 is less than a distance between the first housing plate 221 and the enclosure backplane 11, and the distance between the second housing plate 222 and the enclosure backplane 11 is less than a distance between the third housing plate 223 and the enclosure backplane 11. In this embodiment, the sealing plate 224 and the air baffle 225 of the heat dissipation housing 2 are separately prepared, and then the sealing plate 224 and the air baffle 225 are fastened in a manner of welding, riveting, clamping, screwing, or the like, to form the air duct with a changed cross-sectional area, for improving heat exchange effect of the air duct.

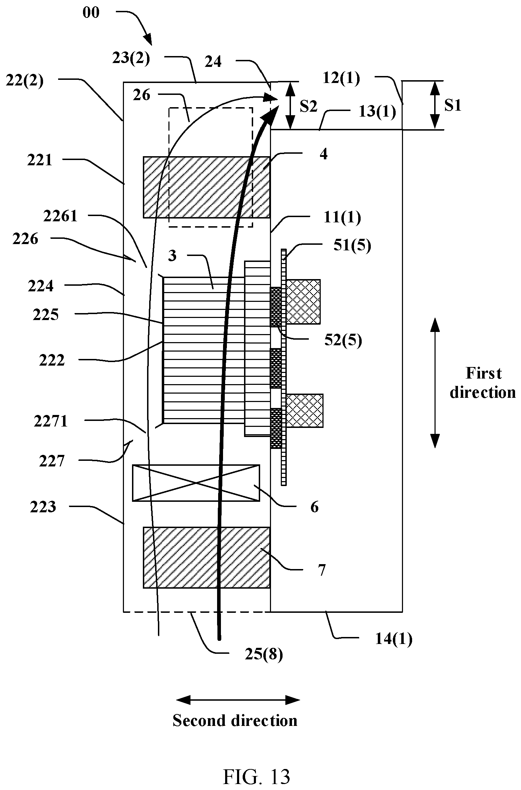

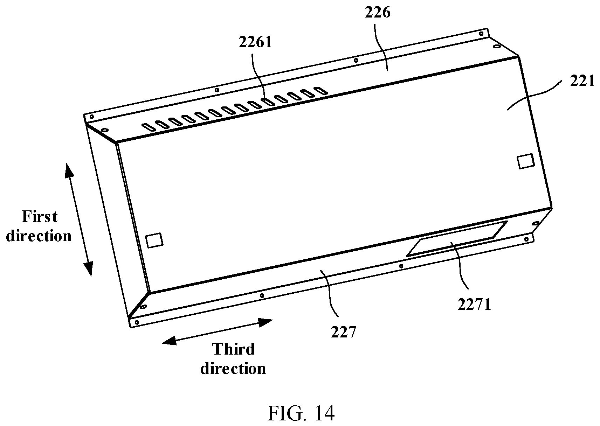

FIG. 13 is another side sectional view of an inverter according to an embodiment of this application. FIG. 14 is another side sectional view of an air baffle according to an embodiment of this application. As shown in FIG. 13 and FIG. 14, the first baffle plate 226 has a first opening 2261 communicating with the first air outlet 24, the second baffle plate 227 has a second opening 2271 communicating with the air inlet 25, and an orthographic projection of the first opening 2261 on the top plate 23 at least partially overlaps an orthographic projection of the first inductor assembly 4 on the top plate 23. Because the first inductor assembly 4 is located downstream of the heat sink 3 and the air baffle 225, the airflow in the air duct is blocked by the air baffle 225, and a region that is of the heat sink 3 and that is opposite to the air baffle 225 easily forms a low-speed airflow region, to affect the heat dissipation effect of the first inductor assembly 4. In view of this, in this embodiment of this application, the first opening 2261 may be provided on the first baffle plate 226 of the air baffle 225, and the second opening 2271 may be provided on the second baffle plate 227. The first baffle plate 226 is located on a side that is of the air baffle 225 and that is close to the first air outlet 24, and the second baffle plate 227 is located on a side that is of the air baffle 225 and that is close to the air inlet 25. Therefore, the first opening 2261 communicates with the first air outlet 24, and the second opening 2271 communicates with the air inlet 25. In this way, an airflow channel may also be formed between the air baffle 225 and the sealing plate 224. A part of the airflow in the air duct flows through the heat sink 3 and then flows to the first inductor assembly 4, and another part of the airflow flows through the air flow channel in the air baffle 225 and then flows to the first inductor assembly 4. The airflow in the airflow channel enters from the second opening 2271 of the second baffle plate, and then flows out from the first opening 2261 of the first baffle plate. The first opening 2261 is opposite to the first inductor assembly 4. The airflow in the airflow channel may be used to directly dissipate heat for the first inductor assembly 4, to improve a problem that a heat dissipation condition of a part of the first inductor assembly 4 is poor due to blockage of the air baffle 225, and improve heat dissipation effect of the part of the first inductor assembly 4 blocked by the air baffle. In this way, airflow conditions at different positions of the first inductor assembly 4 are balanced, and then heat dissipation performance of the inverter 00 can be improved.

In an embodiment, the second housing plate 222 is a flat plate, so that a gap between the second housing plate 222 and the heat sink 3 is uniform, or the second housing plate 222 is in contact with a surface of the heat sink 3. An included angle between the second baffle plate 227 and the second housing plate 222 is an obtuse angle. The second baffle plate 227 may guide an airflow entering from the air inlet 25, so that the airflow in the air duct flows into space between the second housing plate 222 and the enclosure backplane 11 as soon as possible, that is, flows into the heat sink 3 as soon as possible, to increase a flow rate of the airflow at the heat sink 3 and improve the heat dissipation efficiency of the inverter 00. The flat plate is a tilted plate, a curved plate, or the like.

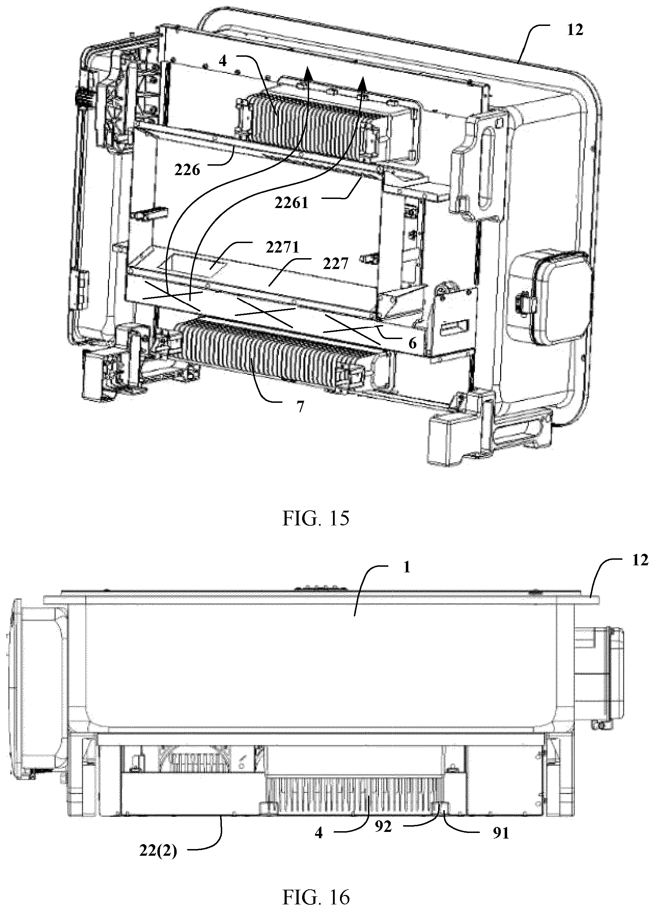

In a specific implementation, FIG. 15 is a diagram of a structure of an inverter according to an embodiment of this application. In the diagram, the sealing plate 224 of the heat dissipation housing 2 is removed, to display a position relationship between the air baffle and a related component. As shown in FIG. 15, the inverter 00 in this embodiment of this application includes the second inductor assembly 7 and a plurality of fans 6. The plurality of fans 6 and the second inductor assembly 7 are separately located in the air duct. The plurality of fans 6 are sequentially arranged in the direction from the first side plate 21a to the second side plate 21b. An air intake side of each fan 6 faces the air inlet 25, and an air exhaust side faces the top plate 23. In this way, a cross section of the air duct is provided with as many fans 6 as possible, to improve air volume in the air duct. The plurality of fans 6 are located between the second inductor assembly 7 and the second baffle plate 227, and the second inductor assembly 7 blocks at least some air vents of some fans 6. In this case, the load of the fan 6 facing the second inductor assembly 7 is large. However, a length of the second inductor assembly 7 in the third direction is likely to be less than a distance between the first side plate 21a and the second side plate 21b. Therefore, some fans 6 in the plurality of fans 6 are not blocked by the second inductor assembly 7. Specifically, the plurality of fans 6 include a first fan 6. An orthographic projection of the first fan 6 on the top plate 23 at least partially overlaps an orthographic projection of the second opening 2271 on the top plate 23, that is, the second opening 2271 at least partially faces the first fan 6; and the orthographic projection of the first fan 6 on the top plate 23 and an orthographic projection of the second inductor assembly 7 on the top plate 23 are at least partially staggered, that is, a part of the first fan 6 is not blocked by the second inductor assembly 7. Alternatively, the first fan 6 includes a first ventilation area, a projection of the first ventilation area in the first direction and a projection of the second inductor assembly 7 in the first direction are staggered, and the projection of the first ventilation area in the first direction at least partially overlaps a projection of the second opening 2271 in the first direction. Specifically, a part that is of the first fan 6 and that is not blocked by the second inductor assembly 7 is opposite to the second opening 2271. In other words, at least some areas of the first opening 2261 and the second inductor assembly 7 are disposed in a staggered manner. Heat dissipation load on the first fan is small, and there is specific surplus load. The surplus load is fully utilized, to improve utilization of the fan, and reduce impact on heat dissipation effect of the heat sink 3 as much as possible.

In a specific embodiment, the first inductor assembly 4 may be a direct current boost inductor assembly, and the second inductor assembly 7 may be an inverter inductor assembly; or the first inductor assembly 4 may be an inverter inductor assembly, and the second inductor assembly 7 may be a direct current boost inductor assembly. Both inductor assemblies are integrated inductor assemblies. Surfaces of the first inductor assembly 4 and the second inductor assembly 7 may each have a plurality of heat sink fins, to improve heat dissipation capabilities of the first inductor assembly 4 and the second inductor assembly 7.

FIG. 16 is a diagram of a sectional structure of an inverter according to an embodiment of this application. As shown in FIG. 16, in this embodiment of this application, a first limiting part 91 is disposed on a side that is of the backplane 22 of the heat dissipation housing 2 and that faces the enclosure 1, a second limiting part 92 is disposed on a side that is of the first inductor assembly 4 and that faces the backplane 22, and the first limiting part 91 is assembled with the second limiting part 92, to limit the first inductor assembly 4 in the direction from the first side plate 21a to the second side plate 21b, and limit the first inductor assembly 4 in the direction from the top plate 23 to the air inlet 25. Through cooperation between the first limiting part 91 and the second limiting part 92, the first inductor assembly 4 is limited in the first direction and the third direction. In a process of installing the inverter 00, the heat dissipation housing 2 may be disposed, so that the backplane 22 of the heat dissipation housing 2 faces a working bench; the second limiting part 92 of the first inductor assembly 4 is assembled with the first limiting part 91 of the backplane 22, to implement pre-positioning of the first inductor assembly 4; and then the enclosure 1 is installed to the heat dissipation housing 2, and the enclosure 1 is connected to the first inductor assembly 4. The assembly process is simple, and there is no need to repeatedly reverse a related component like the enclosure 1 of the inverter 00. This helps improve a yield rate of assembly. In addition, in a process of using the inverter 00, cooperation between the first limiting part 91 and the second limiting part 92 may also improve installation reliability of the first inductor assembly 4, and improve structural stability of the inverter 00.

In a specific embodiment, there are a plurality of specific structures of the first limiting part 91 and the second limiting part 92. For example, the first limiting part 91 may include a limiting pin hole, and the second limiting part 92 may include a limiting pin; or the second limiting part 92 includes a limiting pin hole, and the first limiting part 91 includes a limiting pin. The limiting pin is inserted into the limiting pin hole to implement limiting. Alternatively, the first limiting part 91 may include a limiting slot, and the second limiting part 92 may include a limiting block; or the second limiting part 92 includes a limiting slot, and the first limiting part 91 includes a limiting block. The limiting block is inserted into the limiting slot to implement limiting.

Refer to FIG. 16. In a specific embodiment, the first inductor assembly 4 includes heat dissipation fins, configured to improve heat dissipation efficiency of the first inductor assembly 4. The first limiting part 91 may include a limiting slot, the second limiting part 92 includes the heat dissipation fins of the first inductor assembly 4, and at least a part of the heat dissipation fins is accommodated in the limiting slot. In this embodiment, the heat dissipation fins of the first inductor assembly 4 can be reused, to simplify a structure of the inverter 00. Specifically, at least two heat dissipation fins of the first inductor assembly 4 may further be inserted into at least two limiting slots of the first limiting part 91, to improve limiting effect.

It may be understood that, in this embodiment of this application, a quantity of inductor assemblies disposed in the heat dissipation housing in the inverter is not limited. When a large quantity of inductor assemblies are disposed in the heat dissipation housing, each inductor assembly disposed in the heat dissipation housing may be pre-installed on the backplane of the heat dissipation housing via a limiting assembly, and then the enclosure is installed. For example, the second inductor assembly is used as an example, where a third limiting part may be further provided on a side that is of the backplane and that faces the enclosure, the second inductor assembly includes a fourth limiting part, and the third limiting part is assembled with the fourth limiting part, to limit the second inductor assembly in the direction from the first side plate to the second side plate, and limit the second inductor assembly in the direction from the top plate to the air inlet. Specifically, the second inductor assembly is limited in the first direction and the third direction. Similarly, the heat dissipation fins of the second inductor assembly may also be used as the fourth limiting part, to implement reuse of the heat dissipation fins. In conclusion, for a manner of pre-installing each inductor assembly on the backplane of the heat dissipation housing, refer to the first inductor assembly. Details are not described herein again.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An inverter, wherein the inverter comprises an enclosure, a heat dissipation housing, a fan, and a first inductor assembly, and the heat dissipation housing is fastened to an outer side of an enclosure backplane of the enclosure in a stacked manner, wherein
the heat dissipation housing comprises a first side plate, a second side plate, a backplane, and a top plate, the first side plate and the second side plate are respectively connected to two ends of the backplane, the top plate is connected to the backplane, the first side plate, and the second side plate, and the first side plate, the second side plate, the top plate, the backplane, and the enclosure backplane enclose an air duct; and
an air inlet is provided on a side that is of the air duct and that is away from the top plate, a first air outlet is provided on a side that is of the air duct and that is away from the backplane, and the first air outlet is located at an end that is of the air duct and that is close to the top plate; the fan is located in the air duct, an air intake side of the fan faces the air inlet, and an air exhaust side of the fan faces the top plate; the first side plate has a second air outlet, the second side plate has a third air outlet, the second air outlet is located at an end that is of the first side plate and that faces the top plate, and the third air outlet is located at an end that is of the second side plate and that faces the top plate; and the first inductor assembly is disposed on a side that is of the enclosure backplane and that faces the heat dissipation housing, and a distance between the first inductor assembly and the top plate is less than a distance between the first inductor assembly and the air inlet.

2. The inverter according to claim 1, further comprising a heat sink and a power module, wherein the heat sink is located on the side that is of the enclosure backplane and that faces the heat dissipation housing, the power module is located on a side that is of the enclosure backplane and that is away from the heat dissipation housing, an orthographic projection of the heat sink on the enclosure backplane completely covers an orthographic projection of the power module on the enclosure backplane, the second air outlet is located on a side that is of the heat sink and that is away from the air inlet, and the third air outlet is located on the side that is of the heat sink and that is away from the air inlet.

3. The inverter according to claim 1 or 2, wherein the enclosure further comprises an enclosure cover, an enclosure top plate, and an enclosure bottom plate, the enclosure backplane and the enclosure cover are sequentially arranged in a direction away from the heat dissipation housing, the enclosure top plate is connected to the enclosure backplane and the enclosure cover, the enclosure top plate and the enclosure bottom plate are sequentially arranged in a direction from the first air outlet to the air inlet, and an orthographic projection of the enclosure cover on the backplane of the heat dissipation housing at least partially covers an orthographic projection of the first air outlet on the backplane.

4. The inverter according to claim 3, wherein a distance S1 between an upper edge of the enclosure cover and a surface of the enclosure top plate and a distance S2 between an upper edge of the first air outlet and the surface of the enclosure top plate meet S1≥S2.

5. The inverter according to any one of claims 2 to 4, further comprising a second inductor assembly, wherein the second inductor assembly is disposed on the side that is of the enclosure backplane and that faces the heat dissipation housing, and a distance between the second inductor assembly and the top plate is greater than a distance between the second inductor assembly and the air inlet.

6. The inverter according to claim 5, wherein the fan is located between the heat sink and the second inductor assembly.

7. The inverter according to any one of claims 1 to 6, wherein a shortest distance L1 between the first inductor assembly and the first side plate and a shortest distance L2 between the first inductor assembly and the second side plate meet -5%L1≤L1-L2≤5%L 1.

8. The inverter according to any one of claims 1 to 7, wherein the backplane comprises a first housing plate, a first baffle plate, a second housing plate, a second baffle plate, and a third housing plate that are sequentially connected in a direction from the top plate to the air inlet, a distance between the second housing plate and the enclosure backplane is less than a distance between the first housing plate and the enclosure backplane, and the distance between the second housing plate and the enclosure backplane is less than a distance between the third housing plate and the enclosure backplane.

9. The inverter according to any one of claims 1 to 7, wherein the backplane comprises an air baffle and a sealing plate, the sealing plate comprises a first housing plate and a third housing plate that are spaced apart in a direction from the top plate to the air inlet, the air baffle is fastened to the sealing plate, the air baffle is located between the first housing plate and the third housing plate, the air baffle comprises a first baffle plate, a second baffle plate, and a second housing plate, and the first baffle plate and the second baffle plate are connected to two ends of the second housing plate; and
the first housing plate, the first baffle plate, the second housing plate, the second baffle plate, and the third housing plate are sequentially arranged in the direction from the top plate to the air inlet, a distance between the second housing plate and the enclosure backplane is less than a distance between the first housing plate and the enclosure backplane, and the distance between the second housing plate and the enclosure backplane is less than a distance between the third housing plate and the enclosure backplane.

10. The inverter according to claim 9, wherein the first baffle plate has a first opening communicating with the first air outlet, the second baffle plate has a second opening communicating with the air inlet, and an orthographic projection of the first opening on the top plate at least partially overlaps an orthographic projection of the first inductor assembly on the top plate.

11. The inverter according to claim 10, further comprising the second inductor assembly and a plurality of fans, wherein the plurality of fans and the second inductor assembly are separately located in the air duct, the plurality of fans are sequentially arranged in a direction from the first side plate to the second side plate, and the plurality of fans are located between the second inductor assembly and the second baffle plate; and
the plurality of fans comprise a first fan, an orthographic projection of the first fan on the top plate at least partially overlaps an orthographic projection of the second opening on the top plate, and the orthographic projection of the first fan on the top plate and an orthographic projection of the second inductor assembly on the top plate are at least partially staggered.

12. The inverter according to any one of claims 8 to 11, wherein an included angle between the second baffle plate and the second housing plate is an obtuse angle.

13. The inverter according to any one of claims 1 to 12, wherein a first limiting part is disposed on a side that is of the backplane and that faces the enclosure, a second limiting part is disposed on a side that is of the first inductor assembly and that faces the backplane, and the first limiting part is assembled with the second limiting part, to limit the first inductor assembly in the direction from the first side plate to the second side plate, and limit the first inductor assembly in the direction from the top plate to the air inlet.

14. The inverter according to claim 13, wherein the first limiting part comprises a limiting slot, the second limiting part comprises heat dissipation fins of the first inductor assembly, and at least a part of the heat dissipation fins is accommodated in the limiting slot.
